# EUROPEAN PATENT APPLICATION

(11) **EP 2 843 703 A1**
(43) Date of publication of application: **04.03.2015**
(21) Application number: 14160410.8
(22) Date of filing: 18.03.2014
(51) Int. Cl.: H01L 25/075, H01L 33/50

(54) **Light emitting module and lighting device**

(30) Priority: 29.08.2013 JP 2013178636
(71) Applicant: Toshiba Lighting & Technology Corporation, Yokosuka-shi Kanagawa 237-8510 (JP)
(72) Inventor: Kondo, Kazuya, Kanagawa 237-8510 (JP)
(74) Representative: Willquist, Sofia Ellinor

(57) **Abstract**

According to one embodiment, there is provided a light emitting module (10) including a first light emitting element (121), a first phosphor (141) configured to convert light emitted by the first light emitting element(121), a second phosphor (142) configured to convert the light emitted by the first light emitting element (121), a second light emitting element (122) configured to emit light having a color different from the color of the light emitted by the first light emitting element (121) and the color of the light converted by the first phosphor (141). A light amount of the second light emitting element (122) is a light amount with which an amount of change of a color temperature of light obtained by mixing the light from the first light emitting element (121), the first phosphor (141), the second phosphor (142), and the second light emitting element (122) is within 400 Kelvin.

## Description

### FIELD

Embodiments described herein relate to a light emitting module and a lighting device.

### BACKGROUND

In recent years, as a lighting device, a lighting device including a power-saving light emitting element such as an LED (Light Emitting Diode) is used. The lighting device including such a light emitting element can obtain higher brightness or illuminance with lesser power consumption compared with, for example, a conventional incandescent lamp.

In the lighting device including the light emitting element, a plurality of kinds of light emitting elements having different light emission colors are sometimes mounted on a light emitting module. In this case, light output from the lighting device is light obtained by mixing lights respectively output from the plurality of kinds of light emitting elements mounted on the light emitting module. In other words, a light emission color of the light output from the lighting device is a color obtained by mixing light emission colors of the respective plurality of kinds of light emitting elements.

However, in the related art, an output balance of the lights respectively output by the plurality of kinds of light emitting elements sometimes changes. For example, when temperature characteristics or current characteristics of the light emitting elements mounted on the light emitting module are different, the balance of light outputs from the respective light emitting elements changes during adjustment of brightness corresponding to a change in a driving current or changes according to a change in an environmental temperature.

That is, when temperature characteristics or current characteristics of the respective plurality of kinds of light emitting elements are different, a change in light emission amounts of the light emitting elements varies according to a temperature rise. When the temperatures of the light emitting elements rise, the light emission amounts of the light emitting elements change at amounts of change different from one another. As a result, the balance of light outputs output from the light emitting modules changes. Therefore, a color temperature of light output from the light emitting module as a whole changes.

### BRIEF DESCRIPTION OF THE DRAWINGS

FIG. 1 is a diagram showing an example of the configuration of a lighting device mounted with a light emitting module according to an embodiment;
FIG. 2 is a diagram showing an example of the configuration of the light emitting module according to an embodiment;
FIG. 3 is a diagram showing an example of electric wiring of the light emitting module according to an embodiment;
FIG. 4 is a conceptual diagram for explaining lights emitted by the light emitting module according to an embodiment;
FIG. 5 is a conceptual diagram showing an example of a change with temperature of a light amount of the light emitting module according to an embodiment;
FIG. 6 is a conceptual diagram showing an example of a change with temperature of a light amount of a light emitting module in a comparative example; and
FIG. 7 is an explanatory diagram summarizing a relation between a change in a color temperature and light emitting efficiency.

### DETAILED DESCRIPTION

In view of the problems of the related art, it is an object of the present invention to provide a light emitting module and a lighting device that can suppress a change in an output balance of lights respectively output by a plurality of kinds of light emitting elements.

According to one embodiment, there is provided a light emitting module including: a blue LED, which is an example of a first light emitting element; a red LED, which is an example of a second light emitting element; a yellow phosphor, which is an example of a first phosphor; and a red phosphor, which is an example of a second phosphor. The yellow phosphor converts light emitted by the blue LED into light having a color different from a color of the light emitted by the blue LED. The red phosphor converts the light emitted by the blue LED into light having a color different from the color of the light emitted by the blue LED and the color of the light converted by the yellow phosphor. The red LED emits light having a color different from the color of the light emitted by the blue LED and the color of the light converted by the yellow phosphor. A light amount of the red LED is a light amount with which an amount of change of a color temperature of light obtained by mixing the light emitted by the blue LED, the light emitted by the red LED, the light converted by the yellow phosphor, and the light converted by the red phosphor is equal to or lower than 400 Kelvin, with respect to a change with temperature of the light emitting module. Consequently, the light emitting module can improve light emitting efficiency while suppressing the change with temperature of the color temperature equal to or lower than 400 Kelvin.

In the light emitting module according to the embodiment, the light amount of the read LED may be a light amount with which the amount of change of the color temperature of the light obtained by mixing the light emitted by the blue LED, the light emitted by the red LED, the light converted by the yellow phosphor, and the light converted by the red phosphor is equal to or lower than 200 Kelvin, with respect to a change with temperature of the light emitting module. Consequently, the light emitting module can improve light emitting efficiency while suppressing the change with temperature of the color temperature equal to or lower than 200 Kelvin.

In the light emitting module according to the embodiment, the red phosphor may convert the light emitted by the blue LED into light within a range of a peak wavelength of 600 to 660 nm. The red LED may emit light within a range of a peak wavelength of 590 to 640 nm.

According to another embodiment, there is provided a lighting device including: the light emitting module; and a control section, which is an example of a power control section. The control section controls electric power supplied to the light emitting module. The blue LED and the red LED in the light emitting module emit lights using in common the electric power supplied from the control section. Since it is unnecessary to separately supply different kinds of electric power to the blue LED and the red LED, it is possible to reduce the size of the light emitting module.

A light emitting module and a lighting device according to an embodiment are explained below with reference to the drawings. In the embodiment, components having the same functions are denoted by the same reference numerals and signs and redundant explanation of the components is omitted. The light emitting module and the lighting device explained in the embodiment are only an example and do not limit the present invention. The embodiments may be combined as appropriate to the extent that the embodiments do not contradict each other. Configuration of a lighting device

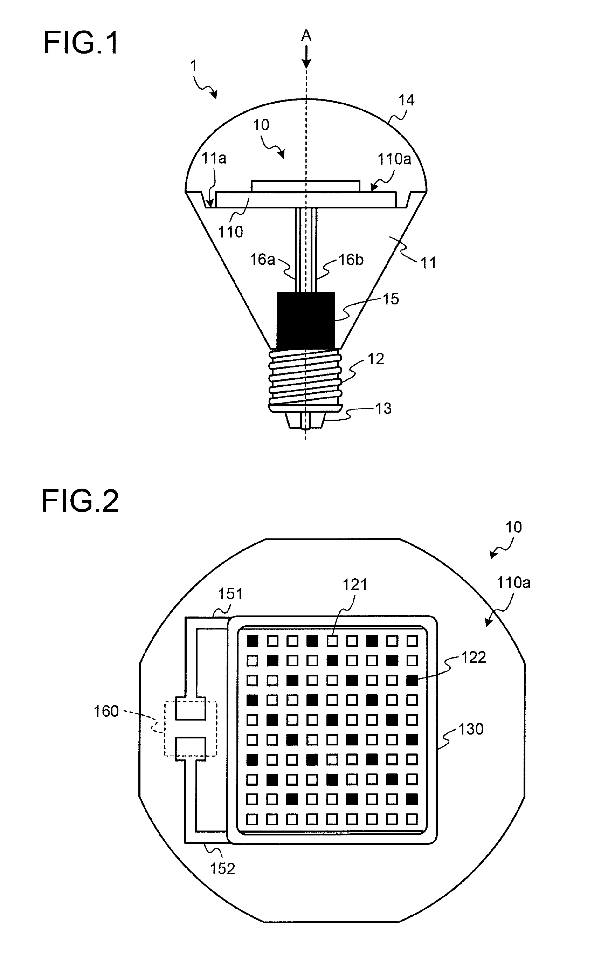

FIG. 1 is a diagram showing an example of the configuration of a lighting device mounted with a light emitting module according to an embodiment. As shown in FIG. 1, a lighting device 1 according to this embodiment includes a light emitting module 10, a main body 11, a cap member 12, an eyelet section 13, a cover 14, a control section 15, an electric wire 16a, and an electric wire 16b. The light emitting module 10 is formed on a board 110 arranged on an upper surface 11a of a main body 11. The board 110 is formed of ceramics having low heat conductivity, for example, alumina, silicon nitride, silicon oxide, or aluminum.

The main body 11 is formed of metal having high heat conductivity, for example, aluminum in a columnar shape substantially circular in a cross section. The cap member 12 is attached to one end of the main body 11. The cover 14 is attached to the other end of the main body 11. The main body 11 is formed such that the outer circumferential surface of the main body 11 forms a taper surface having a substantially conical shape, the diameter of which sequentially increases in a direction from one end toward the other end.

The main body 11 is formed in an external shape approximate to a silhouette of a neck section in a conventional mini-krypton bulb. On the outer circumferential surface of the main body 11, a not-shown large number of thermal radiation fins radially projecting from one end toward the other end are integrally formed.

The cap member 12 is, for example, an E-type cap of an Edison type. The cap member 12 includes a cylindrical shell made of a cooper plate including a thread ridge. The cap member 12 includes a conductive eyelet section 13 provided at an apex at the lower end of the shell via an electrically insulated section. An opening section of the shell is electrically insulated from and fixed to an opening section at one end of the main body 11.

An input line led out from a power input terminal of a not-shown circuit board in the control section 15 is connected to the shell and the eyelet section 13. The cap member 12 is inserted into a socket provided in, for example, the ceiling to supply electric power, which is supplied from the commercial power supply, to the control section 15.

The cover 14 is formed of, for example, milky-white polycarbonate. The cover 14 is formed in a smooth curved surface shape approximated to a silhouette of a mini-krypton bulb having an opening at one end. An opening end portion of the cover 14 is fit in and fixed to the main body 11 to cover a light emitting surface of the light emitting module 10. A method of fixing the cover 14 to the main body 11 may be any of boning, fitting, screwing, and locking.

The control section 15 supplies electric power to the light emitting module 10 provided on the board 110 and controls lighting and extinction of the light emitting module 10. The control section 15 includes a control circuit housed to be electrically insulated from the outside. The control section 15 converts an alternating-current voltage into a direct-current voltage according to the control by the control circuit and applies the converted direct-current voltage to the light emitting module 10 on the board 110. The electric wires 16a and 16b for supplying electric power to the light emitting module 10 on the board 110 are connected to an output terminal of the control circuit of the control section 15.

The electric wires 16a and 16b are led out to an opening section at the other end of the main body 11 via a not-shown through-hole and a not-shown guide groove formed in the main body 11. Insulation coating is peeled from distal end portions of the electric wires 16a and 16b. The distal end portions are connected to a below-mentioned connector 160 arranged on the board 110.

In this way, the control section 15 supplies electric power, which is input via the shell and the eyelet section 13, to the light emitting module 10 on the board 110 via the electric wires 16a and 16b. The control section 15 collects the electric power, which is supplied to the light emitting module 10, via the electric wires 16a and 16b.

### Configuration of the light emitting module

FIG. 2 is a diagram showing an example of the configuration of the light emitting module according to this embodiment. FIG. 2 is a top view showing an example of the configuration of the light emitting module 10 viewed from an arrow A direction in FIG. 1. As shown in FIG. 2, a plurality of blue LEDs 121 and a plurality of red LEDs 122 are arranged on an arrangement surface 110a of the board 110.

Each of the blue LEDs 121 is a light emitting element configured to emit blue-based light having a peak wavelength within a range of, for example, 445 to 465 nm. Each of the red LEDs 122 is a light emitting element configured to emit red-based light having a peak wavelength within a range of, for example, 590 to 640 nm.

In FIG. 2, one blue LED among the plurality of blue LEDs 121 is denoted by reference numeral "121". However, members indicated by the same white square shape are equivalent to the blue LEDs 121. In FIG. 2, one red LED among the plurality of red LEDs 122 is denoted by reference numeral "122". However, members indicated by the same black square shape are equivalent to the red LED 122.

An annular blocking member 130 is arranged on the arrangement surface 110a of the board 110 to surround the blue LEDs 121 and the red LEDs 122. In a recess formed by the inner surface of the blocking member 130 and the arrangement surface 110a of the board 110, below-mentioned resin including a phosphor is filled.

As the resin, resin obtained by adding a phosphor to transparent resin having high diffusibility such as epoxy resin, urea resin, or silicone resin is used. Each of the blue LEDs 121 and the red LEDs 122 is entirely covered with the resin including such a phosphor from above.

The phosphor added to the resin is excited by the blue-based light emitted by the blue LED 121 and emits light having a color different from a color of the light emitted by the blue LED 121. In this embodiment, a yellow phosphor excited by the blue-based light emitted by the blue LED 121 to emit yellow-based light (a peak wavelength is, for example, 540 to 570 nm), which is in a complementary color relation with the blue-based light, is added to the resin.

Consequently, the light emitting module 10 can emit white light as a whole using the blue-based light emitted by the blue LED 121 and the yellow-based light emitted by the yellow phosphor. Besides the yellow phosphor, a green phosphor excited by the light emitted by the blue LED 121 to emit green-based light may be added to the resin.

In this embodiment, a red phosphor excited by the blue-based light emitted by the blue LED 121 to emit red-based light (a peak wavelength is, for example, 600 to 660 nm) is further added to the resin 140. It is possible to improve, with the red-based light emitted by the red phosphor and the red-based light emitted by the red LED 122, color rendering properties of the white light emitted by the light emitting module 10 as a whole.

Wiring patterns 151 and 152 are formed on the arrangement surface 110a of the board 110. The wiring patterns 151 and 152 are electric conductors printed on the board 110. One end of the wiring pattern 151 and one end of the wiring pattern 152 are connected to the connector 160 provided on the board 110.

As shown in FIG. 2, the other end of the wiring pattern 151 and the other end of the wiring pattern 152 are formed in substantially parallel linear shapes on the arrangement surface 110a of the board 110.

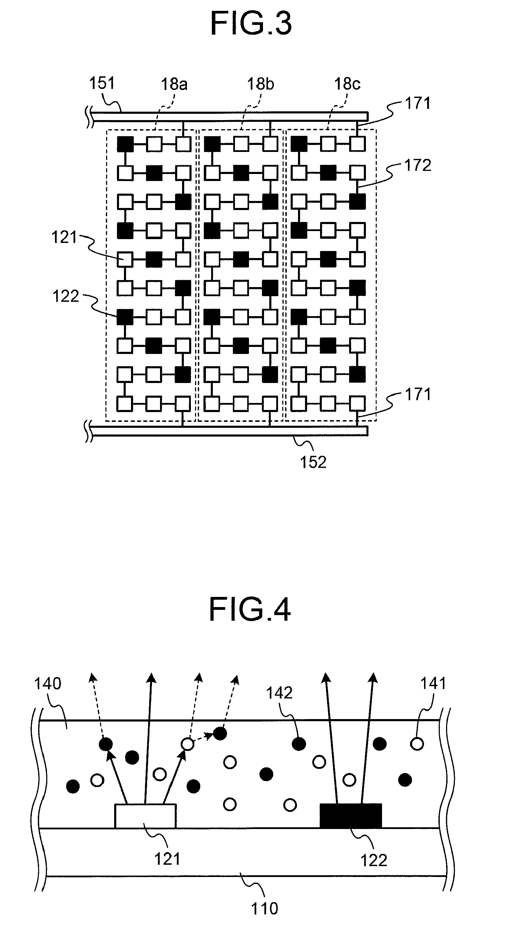

FIG. 3 is a diagram showing an example of electric wiring of the light emitting module according to this embodiment. As shown in FIG. 3, the plurality of blue LEDs 121 and the plurality of red LEDs 122 are arranged in each of a plurality of regions 18a to 18c (in the example shown in FIG. 3, three regions) on the board 110. In each of the regions 18a to 18c, the plurality of blue LEDs 121 and the plurality of red LEDs 122 are connected in series by a bonding wire 172.

In each of the regions 18a to 18c, one end of the plurality of blue LEDs 121 and the plurality of red LEDs 122 connected in series is connected to the other end of the wiring pattern 151, which is formed in a linear shape, by a bonding wire 171. The other end of the plurality of blue LEDs 121 and the plurality of red LEDs 122 connected in series is connected to the other end of the wiring pattern 152, which is formed in a linear shape, by the boding wire 171.

In each of the regions 18a to 18c, as shown in FIG. 3, the plurality of blue LEDs 121 and the plurality of red LEDs 122 connected in series are arranged to meander from the wiring pattern 151 to the wiring pattern 152 while being folded back at every predetermined number (in the example shown in FIG. 3, at every three LEDs) along a linear portion of the wiring pattern 151.

Electric power supplied to the wiring pattern 151 and electric power supplied to the wiring pattern 152 from the control section 15 via the connector 160 are respectively supplied in common to the plurality of blue LEDs 121 and the plurality of red LEDs 122 connected in series in each of the regions 18a to 18c.

FIG. 4 is a conceptual diagram for explaining light emitted by the light emitting module according to this embodiment. The resin 140 includes a yellow phosphor 141 and a red phosphor 142. The blue LED 121 emits blue-based light. The yellow phosphor 141 is excited by the light of the blue LED 121 to emit yellow-based light. The light emitting module 10 emits while light as a whole using the blue-based light emitted by the blue LED 121 and the yellow-based light emitted by the yellow phosphor 141.

The red phosphor 142 is excited by the light of the blue LED 121 to emit red-based light. The red LED 122 emits red-based light. The light emitting module 10 can improve color rendering properties of white light with these red-based lights.

The red phosphor 142 absorbs the light of the blue LED 121 and emits a part of the light as red-based light. Therefore, when the red-based light is generated by the blue LED 121 and the red phosphor 142, a conversion loss occurs. The red phosphor 142 is excited by the light of the blue LED 121 to further absorb yellow-based light emitted by the yellow phosphor 141 and emit a part of the yellow-based light as red-based light. A conversion loss also occurs in that case.

If all red-based lights are generated by the red LED 122, the conversion loss due to the red phosphor 142 does not occur and higher light emitting efficiency is obtained. However, since a change with temperature of a light amount of the red LED 122 is large, in the light emitting module 10 in this embodiment, a generation amount of red-based lights is shared by the red phosphor 142 and the red LED 122.

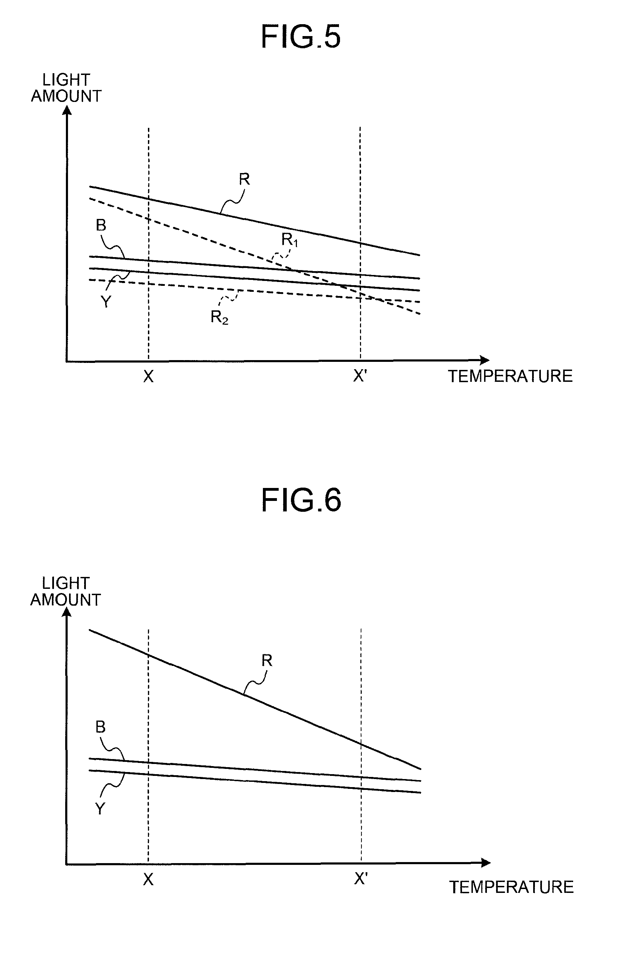

FIG. 5 is a conceptual diagram showing an example of a change with temperature of a light amount of the light emitting module in this embodiment. In FIG. 5, "B" indicates a change with temperature of a light amount of blue-based light emitted by the blue LED 121. "Y" indicates a change with temperature of a light amount of yellow-based light emitted by the yellow phosphor 141 by being excited by the light of the blue LED 121.

"R₁" indicates a change with temperature of a light amount of red-based light emitted by the red LED 122. "R₂" indicates a change with temperature of a light amount of red-based light emitted by the red phosphor 142 by being excited by the light of the blue LED 121. "R" indicates a change with temperature of a light amount obtained by combining "R₁" and "R₂".

In the blue LED 121 and the red LED 122, for example, as indicated by "B" and "R₁" in FIG. 5, the light amounts decrease according to a rise of temperature. An amount of decrease in the light amount involved in the temperature rise is larger in the red LED 122 than the blue LED 121. As indicated by "Y" and "R₂" in FIG. 5, light amounts of yellow-based and red-based lights emitted by the yellow phosphor 141 and the red phosphor 142 by being excited by light of the blue LED 121 show temperature changes substantially the same as the change with temperature of the light amount of the blue LED 121.

When the lighting device 1 is lit, the temperature of the light emitting module 10 rises to a certain degree according to heat generation of the blue LED 121 and the red LED 122. The temperature stabilizes in an equilibrium state of heat generation and heat radiation. The temperature of the light emitting module 10 during the lighting (e.g., "X" in FIG. 5) and the temperature of the light emitting module 10 in a stable state after the lighting (e.g., "X"' in FIG. 5) are different by about several ten °C.

Since change amounts of the light amounts with respect to the temperature change are different in the blue LED 121 and the red LED 122, if the balance of light amounts of lights having the colors emitted by the light emitting module 10 is designed such that a color temperature is a predetermined color temperature in the stable state, a color temperature of light emitted by the light emitting module 10 during the lighting is different from a design value.

If red-based light is generated by only the red LED 122, a relation between an amount of light emitted by the light emitting module 10 and temperature is, for example, as shown in FIG. 6. FIG. 6 is a conceptual diagram showing an example of a change with temperature of a light amount of a light emitting module in a comparative example. In FIG. 6, "R" indicates a change with temperature of a light amount of red-based light emitted by the red LED 122. If the red-based light is generated by only the red LED 122, a light amount necessary for improving color rendering properties of light emitted by the light emitting module 10 as a whole is covered by the red-based light emitted by the red LED 122.

If an amount of the light emitted by the red LED 122 is designed such that a color temperature of light of the light emitting module 10 at the temperature in the stable state ("X"' in FIG. 6) is a predetermined color temperature, at the temperature of the light emitting module 10 during the lighting ("X" in FIG. 6), an amount of light emitted by the red LED 122 is extremely large compared with amounts of lights emitted by the blue LED 121 and the yellow phosphor 141.

Therefore, during the lighting, the balance of amounts of lights having the colors emitted by the light emitting module 10 as a whole greatly deviates from the design value. Consequently, a color temperature of the light emitted by the light emitting module 10 is greatly different during the lighting and in the stable state. In particular, an amount of light emitted by the red LED 122 during the lighting is large compared with amounts of other lights. Therefore, the light emitted by the light emitting module 10 during the lighting is reddish white light having a color temperature lower than the design value.

It is also conceivable to generate red-based light with the blue LED 121 and the red phosphor 142 without using the red LED 122 having the large change with temperature of the light amount. However, when a conversion loss that occurs when the red phosphor 142 converts light emitted by the blue LED 121 into red-based light and a conversion loss that occurs when the red phosphor 142 further converts light converted by the yellow phosphor 141 are taken into account, it is possible to improve the light emitting efficiency of the light emitting module 10 when red-based light is generated using the red LED 122. Therefore, it is undesirable to generate red-based light only with a combination of the blue LED 121 and the red phosphor 142.

Therefore, in the light emitting module 10 according to this embodiment, red-based light is generated by combining the red LED 122 having high light emitting efficiency and the red phosphor 142 that shows a temperature change close to the temperature change of the light amount of the blue LED 121. Consequently, for example, as it is apparent from FIG. 5, it is possible to suppress, compared with the comparative example shown in FIG. 6, the deviation of the balance between an amount of red-based light and amounts of blue-based and yellow-based lights during the lighting and in the stable state.

Consequently, it is possible to suppress a change in a color temperature of white light emitted by the light emitting module 10 during the lighting and in the stable state. Compared with the generation of red-based light only by the combination of the blue LED 121 and the red phosphor 142, the light emitting module 10 can improve light emitting efficiency.

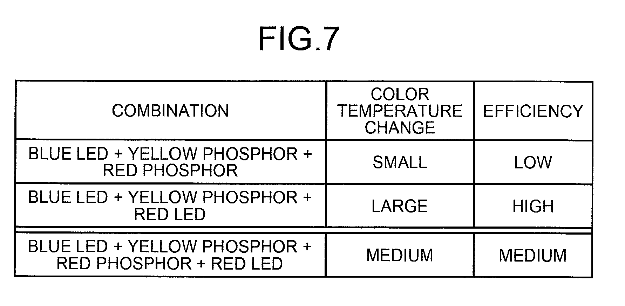

FIG. 7 is an explanatory diagram summarizing an example of a relation between a change in a color temperature and light emitting efficiency. The above explanation is summarized as shown in FIG. 7. When blue-based light is generated by the blue LED 121, yellow-based light is generated by the yellow phosphor 141, and red-based light is generated by the red phosphor 142, for example, as shown in an upper stage of FIG. 7, a temperature change of a color temperature of light emitted by the light emitting module 10 as a whole is small (e.g., about 20 Kelvin). However, in this case, the light emitting efficiency of the light emitting module 10 is deteriorated by a conversion loss, re-absorption, and the like by the red phosphor 142.

When blue-based light is generated by the blue LED 121, yellow-based light is generated by the yellow phosphor 141, and red-based light is generated by the red LED 122, for example, as shown in a middle stage of FIG. 7, a temperature change of a color temperature of light generated by the light emitting module 10 as a whole is large (e.g., about 400 Kelvin).

However, in this case, since the red phosphor 142 is not used, the light emitting efficiency of the light emitting module 10 is relatively high. For example, when the light emitting efficiency of the light emitting module 10 in the configuration in the upper stage in which the blue LED 121, the yellow phosphor 141, and the red phosphor 142 are used is represented as 100%, light emitting efficiency in the configuration in the middle stage in which the blue LED 121, the yellow phosphor 141, and the red LED 122 are used is, for example, about 120%.

On the other hand, in this embodiment in which blue-based light is generated by the blue LED 121, yellow-based light is generated by the yellow phosphor 141, red-based light is generated by the red phosphor 142, and red-based light is generated by the red LED 122, for example, as shown in a lower stage of FIG. 7, it is possible to suppress a change with temperature of a color temperature of light generated by the light emitting module 10 as a whole to a medium degree (e.g., about 200 Kelvin).

In this case, since an amount of the red phosphor 142 can be reduced, it is possible to suppress deterioration in the light emitting efficiency of the light emitting module 10. For example, when the light emitting efficiency of the light emitting module 10 in the configuration in the upper stage in which the blue LED 121, the yellow phosphor 141, and the red phosphor 142 are used is represented as 100%, light emitting efficiency in the configuration in this embodiment in which the blue LED 121, the yellow phosphor 141, the red phosphor 142, and the red LED 122 are used is, for example, about 110%.

In the light emitting module 10 in this embodiment, the number of red LEDs 122, the sizes of the respective red LEDs 122, and the like are designed such that a light amount of the red LED 122 is a predetermined light amount. The predetermined light amount is a light amount with which an amount of change of a color temperature of light obtained by mixing light emitted by the blue LED 121, light converted by the yellow phosphor 141, light converted by the red phosphor 142, and light emitted by the red LED 122 is equal to or lower than 400 Kelvin, with respect to a change with temperature of the light emitting module 10.

In the light emitting module 10 in this embodiment, the predetermined light amount is more preferably a light amount with which an amount of change of a color temperature of light obtained by mixing light emitted by the blue LED 121, light converted by the yellow phosphor 141, light converted by the red phosphor 142, and light emitted by the red LED 122 is equal to or lower than 200 Kelvin, with respect to a change with temperature of the light emitting module 10.

As explained above, as the light emitting module 10 in this embodiment, it is possible to provide the light emitting module 10 having high light emitting efficiency while keeping a change with temperature of a color temperature within an allowable range by increasing an amount of light emitted by red LED 122 within a range in which the change with temperature of the color is within the allowable range.

In the light emitting module 10 in this embodiment, a light amount of the red LED 122 is designed such that a temperature change of a color temperature of light emitted by the light emitting module 10 as a whole is within 400 Kelvin. Consequently, to set a temperature change of a color temperature of white light emitted by the light emitting module 10 within 400 Kelvin, it is unnecessary to separately control electric power supplied to the blue LED 121 and electric power supplied to the red LED 122. Therefore, it is possible to reduce the size of the control section 15 configured to supply electric power to the light emitting module 10. Consequently, it is possible to reduce the size of the lighting device 1.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting module comprising:
a first light emitting element;
a first phosphor configured to convert light emitted by the first light emitting element into light having a color different from a color of the light emitted by the first light emitting element;
a second phosphor configured to convert the light emitted by the first light emitting element into light having a color different from the color of the light emitted by the first light emitting element and the color of the light converted by the first phosphor; and
a second light emitting element configured to emit light having a color different from the color of the light emitted by the first light emitting element and the color of the light converted by the first phosphor, wherein
a light amount of the second light emitting element is a light amount with which an amount of change of a color temperature of light obtained by mixing the light emitted by the first light emitting element, the light converted by the first phosphor, the light converted by the second phosphor, and the light emitted by the second light emitting element is equal to or lower than 400 Kelvin, with respect to a change with temperature of the light emitting module.

2. The module according to claim 1, wherein the light amount of the second light emitting element is a light amount with which the amount of change of the color temperature of the light obtained by mixing the light emitted by the first light emitting element, the light converted by the first phosphor, the light converted by the second phosphor, and the light emitted by the second light emitting element is equal to or lower than 200 Kelvin, with respect to a change with temperature of the light emitting module.

3. The module according to claim 1 or 2, wherein
the first light emitting element is a blue LED configured to emit light having a blue-based color, and
the second light emitting element is a red LED configured to emit light having a red-based color.

4. The module according to claim 3, wherein
the first phosphor converts the light emitted by the blue LED into light having a yellow-based color, and
the second phosphor converts the light emitted by the blue LED into light having a red-based color.

5. The module according to any one of claims 1 to 4, wherein
the second phosphor converts the light emitted by the first light emitting element into light within a range of a peak wavelength of 600 to 660 nm, and
the second light emitting element emits light within a range of a peak wavelength of 590 to 640 nm.

6. A lighting device comprising:
the light emitting module according to any one of claims 1 to 5; and
a power control section configured to control electric power supplied to the light emitting module.

7. The lighting device according to claim 6, wherein the first light emitting element and the second light emitting element in the light emitting module emit lights using in common electric power supplied from the power control section.
